(19) Europäisches Patentamt / European Patent Office / Office européen des brevets

(11) **EP 4 060 834 A1**

(12) **EUROPEAN PATENT APPLICATION**
published in accordance with Art. 153(4) EPC

(43) Date of publication:
**21.09.2022 Bulletin 2022/38**

(21) Application number: **20886394.4**

(22) Date of filing: **28.10.2020**

(51) International Patent Classification (IPC):
**H01S 5/183** (2006.01)    **H01S 3/11** (2006.01)
**H01S 5/14** (2006.01)

(52) Cooperative Patent Classification (CPC):
**H01S 3/11; H01S 5/14; H01S 5/183**

(86) International application number:
**PCT/JP2020/040375**

(87) International publication number:
**WO 2021/095523 (20.05.2021 Gazette 2021/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.11.2019 JP 2019207122**

(71) Applicant: **NICHIA CORPORATION**
**Tokushima 774-8601 (JP)**

(72) Inventors:
• **TAKANO, Tetsushi**
  **Anan-shi, Tokushima 774-8601 (JP)**
• **OGAWA, Hisashi**
  **Anan-shi, Tokushima 774-8601 (JP)**

(74) Representative: **Betten & Resch**
**Patent- und Rechtsanwälte PartGmbB**
**Maximiliansplatz 14**
**80333 München (DE)**

(54) **VERTICAL EXTERNAL-CAVITY SURFACE-EMITTING LASER**

(57) There is provided a vertical external-cavity surface-emitting laser configured to output light pulses. The vertical external-cavity surface-emitting laser includes a resonator having at least two mirrors, a semiconductor laser medium disposed in the resonator, and a Q switch provided in the resonator.

EP 4 060 834 A1

FIG.2

## Description

Technical Field

The present invention relates to vertical external-cavity surface-emitting lasers.

Background Art

A Q-switch laser is a laser configured to output light pulses with a laser medium and a Q switch disposed inside an optical resonator by switching the amplification factor of the resonator using the Q switch. For a laser medium, there is known a configuration employing single crystal (yttrium aluminium garnet (YAG) or the like) containing an active material (a rare earth ion of Yb, Nd, or the like) having a lifetime sufficiently longer than a period in which light travels in a repeating manner in the resonator, glass, or the like (for example, see Patent Literature (PTL) 1).

There is also known a configuration in which an end surface of a laser medium is used as one of the reflective surfaces of an optical resonator, and pulse oscillation is produced by exciting the laser medium and switching a Q switch inside the optical resonator (for example, see PTL 2).

In general, a Q switch transforms energy accumulated in a gain medium as population inversion to a light pulse having high energy by switching a Q factor from low to high, and outputs the light pulse. Thus, an active material having a lifetime sufficiently longer than a period in which light travels in a repeating manner in the resonator is desirable as the medium.

Vertical external-cavity surface-emitting lasers (hereinafter also referred to as "VECSELs") are surface emitting lasers configured to produce laser oscillation by photoexcitation or current excitation. Light generated from a surface emitting semiconductor chip (VECSEL chip) is amplified by an optical resonator constituted of at least one mirror and is oscillated. The excitation lifetime of an optical semiconductor is substantially on the order of sub-nanoseconds (ns), which is often shorter than a period in which light travels in a repeating manner in the optical resonator. This makes it difficult to obtain a pulse with high peak power by constituting a Q-switch laser by the VECSEL.

Citation List

Patent Literature

PTL 1: JP 2008-177226 A
PTL 2: JP 4-42979 A

Summary of Invention

Technical Problem

An object of certain embodiments of the present invention is to provide a surface emitting semiconductor laser configured to output pulses with high peak power.

Solution to Problem

In a first aspect of the present invention, a vertical external-cavity surface-emitting semiconductor laser includes a resonator having at least two mirrors, a semiconductor laser medium disposed in the resonator, and a Q switch provided in the resonator.

Advantageous Effects of Invention

According to certain embodiments, a vertical external-cavity surface-emitting laser configured to output a pulse with high peak power is achieved.

Brief Description of Drawings

FIG. 1A is a diagram explaining a basic principle according to an embodiment of the present invention and illustrating accumulation of light power into a resonator.
FIG. 1B is a diagram explaining a basic principle according to an embodiment of the present invention, and is also a diagram illustrating switching from a high Q to a low Q.
FIG. 2 is a schematic diagram of a vertical external-cavity surface-emitting laser of a first embodiment.
FIG. 3 is a diagram illustrating a configuration example of a VECSEL chip in FIG. 2.
FIG. 4 is a diagram explaining operations of a vertical external-cavity surface-emitting laser of the first embodiment.
FIG. 5A is a diagram showing resonator characteristics (light power transmittance) of a vertical external-cavity surface-emitting laser of the first embodiment.
FIG. 5B is a diagram showing resonator characteristics (power inside a resonator) of a vertical external-cavity surface-emitting laser of the first embodiment.
FIG. 5C is a diagram showing resonator characteristics (resonator output) of a vertical external-cavity surface-emitting laser of the first embodiment.
FIG. 6A is an enlarged view of a portion near a pulse output point in FIG. 5A.
FIG. 6B is an enlarged view of a portion near a pulse output point in FIG. 5B.
FIG. 6C is an enlarged view of a portion near a pulse output point in FIG. 5C.

FIG. 7A is a diagram explaining basic operations of a vertical external-cavity surface-emitting laser of a second embodiment, and is also a diagram illustrating accumulation of light power into a resonator.

FIG. 7B is a diagram explaining basic operations of a vertical external-cavity surface-emitting laser of the second embodiment, and is also a diagram illustrating switching from a high Q to a low Q.

FIG. 8 is a diagram illustrating a configuration example of a vertical external-cavity surface-emitting laser of the second embodiment.

FIG. 9 is a modification example of a vertical external-cavity surface-emitting laser of the second embodiment.

Description of Embodiments

A laser medium with a short excitation lifetime, such as a semiconductor laser may not sufficiently store energy in a non-equilibrium state, so that pulses with high peak power may not be oscillated by a Q switch that performs general operations. On the other hand, semiconductor lasers have advantages such as low cost, compactness, low power consumption, wavelength design being possible, being easy to use and the like, and thus it is desired to achieve a semiconductor laser that can output pulses with high peak power.

In certain embodiments, a semiconductor laser is used as a laser medium. Energy is not accumulated in the laser medium, but light energy is accumulated in a resonator. When sufficient energy has been accumulated in the resonator, a Q factor of the resonator is switched from high to low to output a light pulse. It is difficult to obtain a high Q factor when optical loss of the resonator is large, and therefore a surface-emitting laser with low optical loss, such as a VECSEL, an optically pumped semiconductor laser (hereinafter, also referred to as "OPSL") or the like, is suitable for use. Causing injection synchronization light to enter from the outside makes it possible to control the center wavelength of pulse output.

Basic Principle

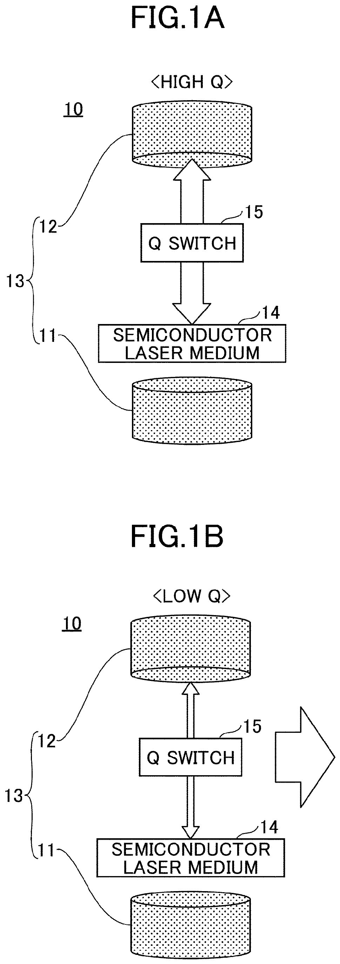

FIGS. 1A and 1B are diagrams each explaining a basic principle according to an embodiment of the present invention. A vertical external-cavity surface-emitting laser 10 includes a resonator 13 having at least two mirrors 11 and 12, a semiconductor laser medium 14 disposed in the resonator 13, and a Q switch 15 provided in the resonator 13.

When a carrier of the semiconductor laser medium 14 is excited to the conduction band, light is emitted by recombination. Light is emitted from the semiconductor laser medium 14 when population inversion is obtained by induced emission. The emitted light reciprocates between the mirror 11 and the mirror 12 to be amplified. During this time, the transmittance of the Q switch is set to be high as illustrated in FIG. 1A, and the Q factor of the resonator 13 is maintained high. When the power accumulated in the resonator 13 becomes equal to or higher than a certain level, the Q factor is switched to the low side to release the power accumulated in the resonator 13, as illustrated in FIG. 1B.

The Q factor is a dimensionless quantity representing continuous characteristics of vibrations of a resonant system, and is generally expressed by a ratio of a resonant frequency to the line width (FWHM) of the resonant frequency. As the Q factor becomes high, the system resonates in a more stable manner and energy therein further increases.

When the energy inside the resonator 13 becomes sufficiently high, the Q switch 15 drops the Q factor at once to release the energy. Consequently, a light pulse having high energy is output from the vertical external-cavity surface-emitting laser 10.

This configuration is fundamentally different from a configuration of a general Q-switch laser, that is, a configuration in which the Q factor is maintained to be low while light energy is accumulated in a gain medium, and the Q factor is increased for oscillation when the energy is stored.

The semiconductor laser medium 14 can oscillate with a desired fundamental wavelength by controlling material, composition, film thickness of the quantum well layer, the number of laminated layers, and the like of the semiconductor, and can be miniaturized. Pulsed light having high power may be output using the compact and inexpensive semiconductor laser medium 14 by the amplification of the light in the resonator 13 and the switching from the high Q factor to the low Q factor.

First Embodiment

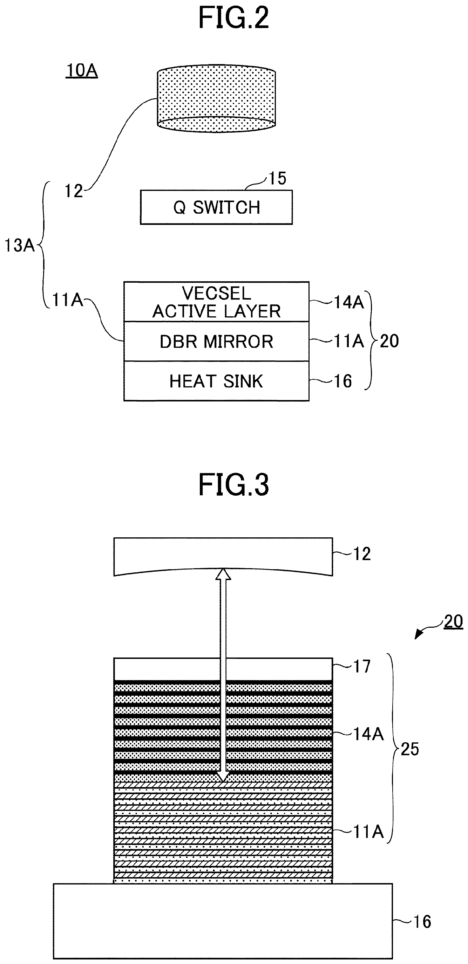

FIG. 2 is a schematic diagram of a vertical external-cavity surface-emitting laser 10A of a first embodiment. The vertical external-cavity surface-emitting laser 10A includes a VECSEL chip 20, the mirror 12, and the Q switch 15.

The VECSEL chip 20 has a configuration in which, by way of example, a heat sink 16, a distributed Bragg reflector (hereinafter, also referred to as "DBR") mirror 11A, and a VECSEL active layer 14A are laminated in that order. The VECSEL active layer 14A is a gain medium in which an excitation absorbing layer and an active layer are alternately laminated, and is an example of the semiconductor laser medium 14. The DBR mirror 11A forms a resonator 13A along with the mirror 12.

The VECSEL active layer 14A is, for example, a surface-emitting laser designed to have a desired fundamental wavelength, and is excited by light irradiation from the outside or current injection. The Q switch 15 switches the Q factor to the low side when the light power accumulated inside the resonator 13A rises up to a predetermined value or higher, thereby releasing the accumulated light power at once. In the schematic diagram of FIG. 2, the Q switch 15 is depicted between the mirror 12 and the VECSEL chip 20 for convenience, but the embodiment is not limited to this example, and the mirror 12 may have the function of the Q switch 15.

FIG. 3 is a configuration example of the VECSEL chip 20. A laminated body 25 including the DBR mirror 11A and the VECSEL active layer 14A is supported on the heat sink 16. The heat sink 16 is any substrate that can support the entire VECSEL chip 20 and release the heat therefrom. Depending on the type of semiconductor material used in the laminated body 25 on the substrate, GaAs, InP, GaInP, GaAsN, GaN, Si, Ge, $Al_2O_3$, MgO, SiC, and the like can be used as the substrate. Here, as an example, a GaAs substrate is used.

The DBR mirror 11A is formed on the substrate that functions as the heat sink 16, by alternately laminating semiconductor layers each having a different refractive index with a thickness of approximately a quarter-wavelength. As an example, thin films of GaAlAs and GaAs are alternately laminated to form the mirror with a reflectance of 99.9%.

The VECSEL active layer 14A is, by way of example, an excitation absorbing layer having a quantum well structure, and is a laser medium that can produce surface emission. Selecting the material of the quantum well layer makes it possible to design the oscillation wavelength over a wide range. When used for long-distance optical communications, a surface-emitting laser with low transmission loss in a range from the band of 1.3 $\mu$m to the band of 1.6 $\mu$m may be designed. When used for mediumdistance optical fiber communications, a surface-emitting laser in a range from the band of 0.8 $\mu$m to the band of 1.0 $\mu$m may be designed. In the example herein, for example, a multiple quantum well is formed by repetitively laminating up to 10 layers of an InGaAs/GaAsP quantum well with a thickness of 8 nm.

A light confinement layer 17 may be disposed on the uppermost surface of the VECSEL active layer 14A. The light confinement layer 17 suppresses dissipation of light generated by spontaneous emission and efficiently leads to induced emission. The VECSEL chip 20 can be fabricated using an established semiconductor technology, and a large number of VECSEL chips can be cut out from a wafer.

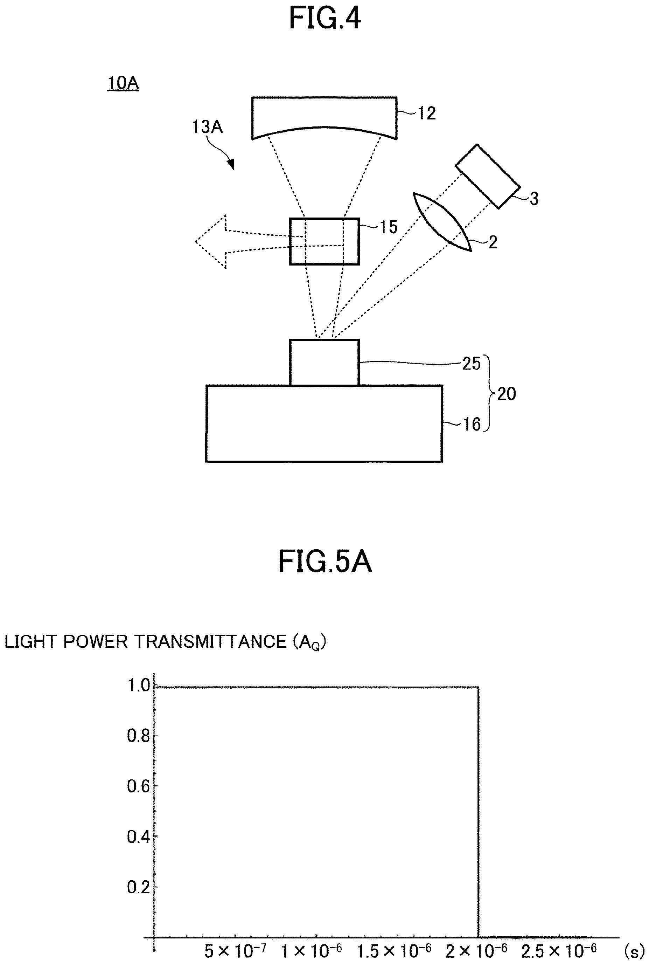

FIG. 4 is a diagram explaining operations of a gain portion using the VECSEL chip 20. The vertical external-cavity surface-emitting laser 10A uses, for example, a laser medium having a fundamental oscillation wavelength of 980 nm. As described above with reference to FIG. 3, the laser medium is the VECSEL active layer 14A of the surface emitting type incorporated into the laminated body 25 together with the DBR mirror 11A.

In the example of FIG. 4, the VECSEL chip 20 is excited by the irradiation of an excitation light source 3. The excitation light source 3 is, for example, a continuous wave (CW) laser configured to output excitation light having a wavelength of 808 nm, or an intermittent CW laser that can produce a pseudo continuous oscillation (continuous oscillation time is equal to or longer than microseconds). The beam diameter of light that is output from the excitation light source 3 is reduced by a condensing lens 2, and the light is incident on the VECSEL active layer 14A of the VECSEL chip 20.

Light excited by the excitation light source 3 and emitted from the VECSEL active layer 14A reciprocates between the mirror 12 and the DBR mirror 11A in the laminated body 25. The mirror 12 is disposed at a position at which the light, when having made one reciprocation movement in the resonator 13A, overlaps the original light path. The number of mirrors that constitute the resonator 13A is not limited to two, and two or more mirrors may be combined to constitute a ring-type resonator. In this case as well, each of the mirrors is disposed such that the light overlaps the original light path when having made one circulation movement in the resonator.

While light reciprocates between the mirror 12 and the DBR mirror 11A, the Q factor in the resonator 13A is maintained to be high by the Q switch 15. The Q factor of the resonator 13A is defined as follows.

$$Q \equiv \nu/\Delta\nu \qquad (1)$$

In the above expression, $\nu$ is the center frequency of a frequency spectrum, and $\Delta\nu$ is the full width at half maximum (FWHM) of the frequency spectrum. When an external impact such as vibration, thermal expansion or the like is sufficiently small, it is known that $\Delta\nu$ is expressed as follows.

$$\Delta\nu = h\nu\Theta(1 - A_{RT})/4\pi T_{RT}^2 P_{intra} \qquad (2)$$

In the above equation, h is a Planck constant, $\Theta$ is a spontaneous emission light factor (the generation ratio of spontaneous emission and induced emission), $T_{RT}$ is a period of time in which light makes a round-trip in the resonator, and $P_{intra}$ is light power in the resonator. $A_{RT}$ is the product of light attenuation per one circulation movement in the resonator including maximum transmittance $A_Q^{MAX}$ of light power of the Q switch 15. The Q factor is higher as $A_{RT}$ is closer to 1, and $A_{RT}$ is limited by $A_Q^{MAX}$. This is because $A_{RT}$ is determined by multiplying $A_Q^{MAX}$ by other light attenuation.

When light power is accumulated up to a predetermined level or more inside the resonator 13A, the Q switch 15 is switched from a high Q-value side to a low Q-value side so as to release the accumulated light power at once. Thus, pulsed light is output from the vertical external-cavity surface-emitting laser 10A.

The Q switch 15 can extract the light pulse and control the Q factor of the resonator 13A by changing power transmittance $A_Q$ of the light. The efficiency of confining the light power to the resonator is improved as the Q factor increases. Accordingly, the characteristics of the Q switch 15 are preferably such that the response speed is fast and the maximum transmittance $A_Q^{MAX}$ of the light power is large. This is because when $A_Q^{MAX}$ is small, $A_{RT}$ is also small, which makes it difficult to set the Q factor to be high from Equations (1) and (2).

The Q switch 15 may be of any type, such as a mechanical switching element, an acoustic switching element, an electro-optical switching element, a switching element of a magnetic body and the like. The mechanical Q switch is, for example, a rotatable mirror, and a pulse is output to the outside of the resonator 13A by mechanically changing the angle of the mirror. The mechanical Q switch is used in applications that do not require a high response speed (on the order of milliseconds). The maximum transmittance $A_Q^{MAX}$ can be set to be equal to or greater than 99.9% depending on an arrangement.

The acoustic Q switch applies ultrasonic waves to a crystal at a pulse output timing to excite a phonon of the crystal and diffract the light. A relatively fast response speed (several hundred nanoseconds) is achieved, but the maximum transmittance $A_Q^{MAX}$ is approximately 95%.

The electro-optical Q switch is constituted by, for example, a combination of an electro-optical crystal and a polarizing beam splitter (PBS). A voltage, a current, an electric signal, or the like is applied to the electro-optical crystal, polarized light is rotated by using an electro-optical effect, and any one of polarization components is taken out by the PBS. The response speed is significantly fast (several nanoseconds), and the maximum transmittance $A_Q^{MAX}$ is approximately 99%.

Alternatively, the mirror 12 may have variable reflectance to function as the Q switch 15. The Q switch 15 suitable for individual applications can be used in accordance with the characteristics such as the response speed of the switch, the maximum transmittance $A_Q^{MAX}$, and the like. The same operations are performed even when the vertical external-cavity surface-emitting laser 10A is excited by a current.

FIGS. 5A to 5C are diagrams each showing resonator characteristics of the vertical external-cavity surface-emitting laser 10A of the first embodiment. Simulation parameters are as follows.

- The resonator length is 1 m (2 m per reciprocation);
- The light emission wavelength of the VECSEL active layer 14A of the VECSEL chip 20 is 980 nm, the gain factor is 2000 $cm^{-1}$, and the reflectance of the DBR mirror is 99.9%;
- The light confinement factor in a longitudinal direction of a periodic gain structure of the resonator is 2.0;
- The response speed of the Q switch 15 is one nanosecond and the maximum transmittance $A_Q^{MAX}$ thereof is 99%;
- The excitation light source 3 is a CW laser with a wavelength of 808 nm and output power of 100 W; and
- The spot diameter on the light emitting surface of the VECSEL chip 20 is 100 $\mu$m.

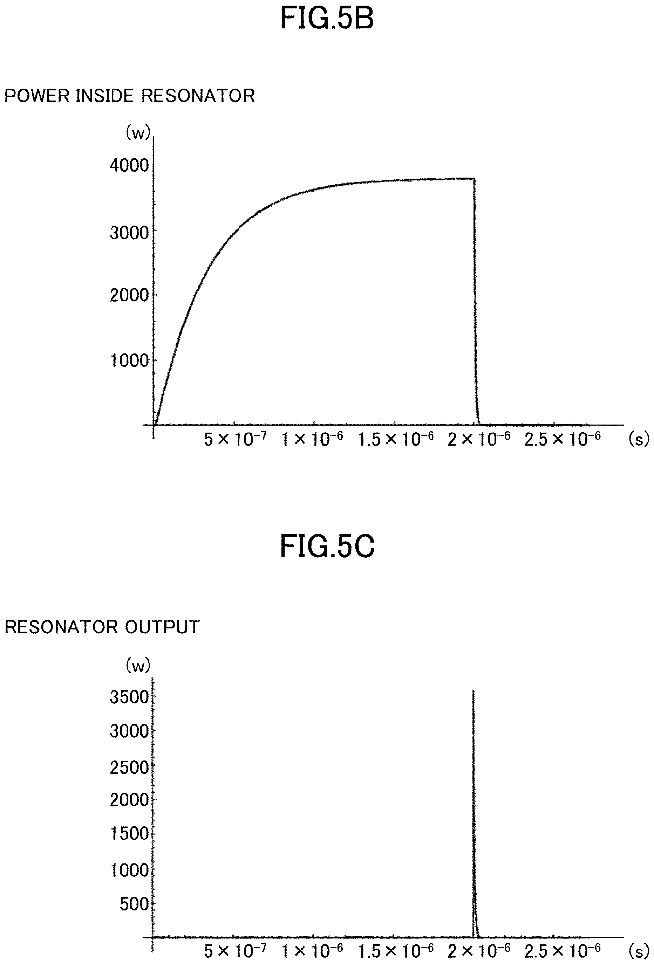

FIG. 5A depicts the power transmittance $A_Q$ of the Q switch, FIG. 5B shows power in the resonance, and FIG. 5C shows output of the resonator. In any of these drawings, the horizontal axis is time (s). The calculation is started from a state in which power in the resonator is nearly 0. In FIG. 5A, an initial value of the power transmittance $A_Q$ is set to the maximum transmittance $A_Q^{MAX}$ ($A_Q^{MAX}$ = 0.99), and the Q factor is set to be high. The excitation is started at time 0.

In FIG. 5B, simultaneously with the start of incidence of excitation light, power (W) in the resonator gradually increases. When the power in the resonator approaches or has reached a steady-state value (at two microseconds or approximately two microseconds), the $A_{Q\,factor}$ is lowered to 0 in about one nanosecond to extract pulsed light. The Q factor of the resonator and the power in the resonator decrease at once, and a pulse output is acquired. In FIG. 5C, a pulse output of 3500 W is acquired immediately after the switching.

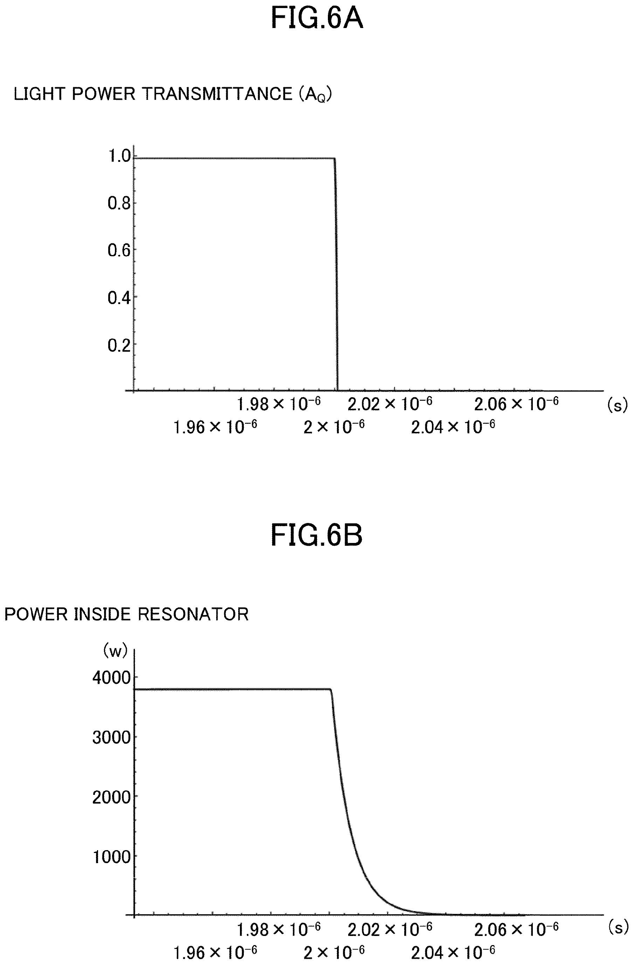

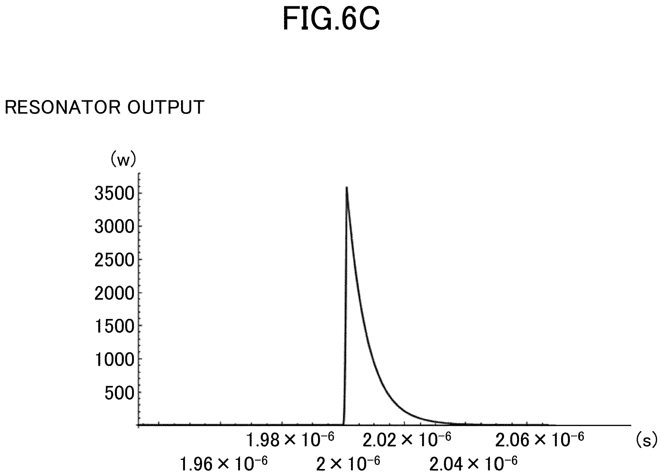

FIGS. 6A to 6C are enlarged views near two microseconds of FIGS. 5A to 5C, respectively. Corresponding to FIGS. 5A to 5C, FIG. 6A shows the power transmittance $A_Q$, FIG. 6B shows the power in the resonator, and FIG. 6C shows the output of the resonator. Immediately after the switching of the Q switch, that is, immediately after the switching of the $A_Q$ factor, the power in the resonator is reduced at once, and a pulse with maximum power of 3500 W is output from the resonator. The pulse output is reduced to be 1/e in approximately seven nanoseconds therefrom. This substantially matches the time when the light makes a round-trip in the resonator.

It is understood from FIGS. 5A to 5C and FIGS. 6A to 6C that the VECSEL 10A using the inexpensive VECSEL chip 20 makes it possible to obtain a high power pulse output.

Second Embodiment

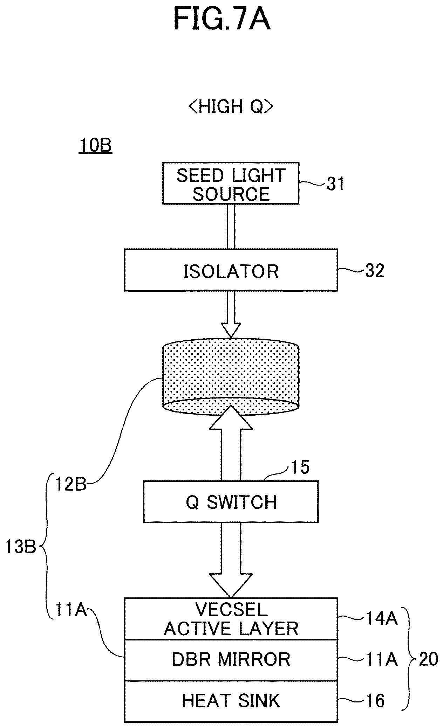

FIGS. 7A and 7C illustrate basic operations of a vertical external-cavity surface-emitting laser 10B of a second embodiment. In the second embodiment, separate from the above-described excitation source, a seed light source 31 for injection synchronization is used. Injection synchronization is a technique in which external light of a single wavelength with a stable frequency is injected into a self-excited oscillator with high energy, so as to synchronize the oscillation output with the external light. By performing injection synchronization, the center wavelength of a light pulse output from a resonator 13B of the vertical external-cavity surface-emitting laser 10B may be controlled.

The seed light source 31 is, for example, a single longitudinal mode CW laser, which is, by way of example, an external cavity diode laser (ECDL) with a stable frequency tuned to a desired frequency. In FIG. 7A, injection synchronization light that is output from the seed light source 31 is input to the resonator 13A via an isolator 32 before a Q factor of the resonator 13B is switched from a high Q factor to a low Q factor by the Q switch 15.

In this example, the injection synchronization light enters from a surface of a mirror 12B constituting the resonator 13B on a side opposite a surface of the mirror 12B facing a VECSEL active layer 14A. A highly reflective film, for example, is formed on the surface of the mirror 12B facing the VECSEL active layer 14A, and an antireflection coating is formed on the surface of the mirror 12B on the opposite side to the surface facing the VECSEL active layer 14A. The isolator 32 controls the injection synchronization light such that the light travels only in one direction, and suppresses a situation in which leakage light from the resonator 13A enters the seed light source 31.

The resonator 13B is constituted of, for example, the mirror 12B and a DBR mirror 11A formed on a heat sink 16 of a VECSEL chip 20. The configuration of the VECSEL chip 20 is the same as that of the VECSEL chip 20 used in the first embodiment, for example, and includes the quantum well-type VECSEL active layer 14A laminated on the upper side of the DBR mirror 11A as illustrated in FIG. 3.

As described below, the resonator length of the resonator 13B is set to an integral multiple of the wavelength of the injection synchronization light. In order to maintain the resonator length at an integral multiple of the wavelength of the injection synchronization light, at least one of the mirror 12B and the VECSEL chip 20 may be provided with a drive mechanism (for example, an actuator) for adjusting the resonator length.

The VECSEL active layer 14A inside the resonator 13B is excited by excitation light from the outside or an injection current, thereby light being emitted. The emitted light reciprocates inside the resonator 13A and is amplified. During this time, the Q factor of the resonator 13A is maintained high, and the resonator 13A is in a state of a self-excited oscillator with high energy.

When the injection synchronization light is injected by the Q switch 15 before the Q factor is switched to the low value, the wavelength of the light reciprocating inside the resonator 13A is synchronized with the wavelength of the injection synchronization light.

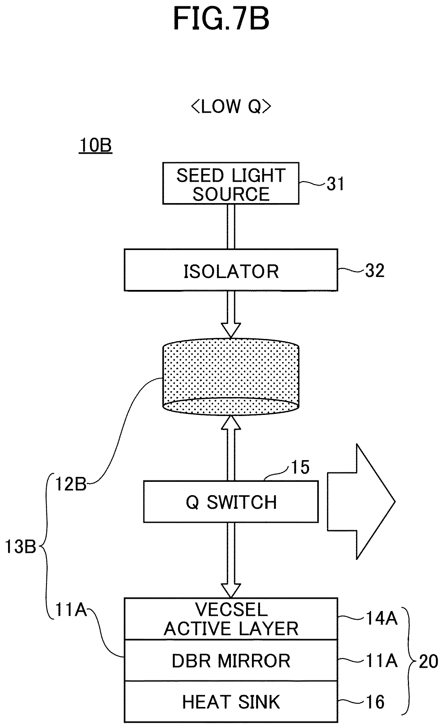

In FIG. 7B, when the light power inside the resonator 13B becomes sufficiently high, the Q switch 15 is switched to the low Q factor side to output a light pulse with high power from the resonator 13B. The center wavelength of the light pulse matches the wavelength of the injection synchronization light. By adopting the configuration of FIGS. 7A and 7B, a high-power light pulse that is controlled to have a desired wavelength can be output by using the inexpensive VECSEL chip 20.

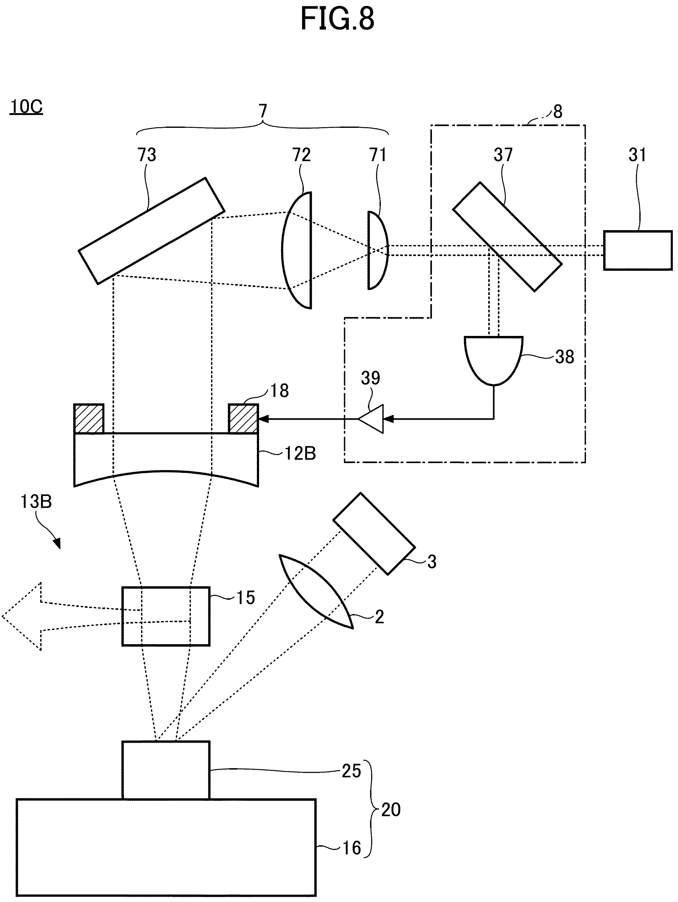

FIG. 8 is a configuration example of a vertical external-cavity surface-emitting laser 10C. The vertical external-cavity surface-emitting laser 10C includes the mirror 12B and the VECSEL chip 20 facing each other. As described above with reference to FIGS. 7A and 7B, the DBR mirror 11A and the VECSEL active layer 14A are laminated in that order in the laminated body 25 formed on the heat sink 16 of the VECSEL chip 20. The resonator 13B is constituted of the DBR mirror 11A and the mirror 12B.

The VECSEL active layer 14A is excited by excitation light that enters from the external excitation light source 3. The excitation light has its beam diameter reduced by the condensing lens 2, and is incident on the VECSEL active layer 14A. Light emitted from the VECSEL active layer 14A by photoexcitation is amplified by the resonator 13B.

The Q switch 15 is provided in the resonator 13B. As described above, the Q switch 15 may take any configuration in which the Q factor of the resonator 13A can be switched from the high Q factor to the low Q factor, such as a mechanical switch, an acoustic switch, an electro-optical switch and the like. Alternatively, the mirror 12B may function as the Q switch 15.

The vertical external-cavity surface-emitting laser 10C includes the seed light source 31 configured to output injection synchronization light and an optical system 7 for transverse mode adjustment configured to adjust the transverse mode of the injection synchronization light to enter the resonator 13B. A feedback system 8 for longitudinal mode adjustment configured to match the injection synchronization light and the resonant frequency of the resonator 13B may be provided. In this case, for example, the mirror 12B may be provided with an actuator 18 for feedback control of the resonant frequency of the resonator 13B.

The optical system 7 for transverse mode adjustment includes, for example, a lens 71, a lens 72, and a mirror 73, and shapes the transverse mode of the injection synchronization light so that the injection synchronization light is coupled to the resonator 13B. The optical system 7 for transverse mode adjustment is not limited to the arrangement example of FIG. 8. By appropriately disposing appropriate optical elements, the transverse mode of the injection synchronization light to enter the resonator 13B may be adjusted before the Q factor is switched to the low Q factor side.

When the seed light source 31 is of a single transverse mode, an intensity distribution of light in a cross section orthogonal to the optical axis takes a Gaussian distribution (TEMoo mode). It is desired that both the intensity distribution in a horizontal direction (horizontal transverse mode) and the intensity distribution in a vertical direction (vertical transverse mode) of the above cross section match the transverse mode distribution of light resonating inside the resonator 13B.

The above-described transverse modes may be matched by appropriately designing the seed light source 31 and the resonator 13B and arranging them at appropriate positions without using the optical system 7 for transverse mode adjustment.

The feedback system 8 includes a mirror 37 for extracting the light, a photodetector 38, and a feedback circuit 39. The photodetector 38 detects interference light of part of the injection synchronization light and part of the light reciprocating in the resonator 13B, and transforms the detected light into an electric signal. The feedback circuit 42 identifies, from the electric signal, a difference between the frequency of the seed light source 31 and the resonant frequency of the resonator 13B, and controls an actuator 18 such that the above difference becomes zero or is minimized.

The actuator 18 performs fine adjustment on a position of the mirror 12B to set the resonator length (the length the light travels in one reciprocation movement or one circulation movement) to an integral multiple of the wavelength of the injection synchronization light. In the configuration example of FIG. 8, information on the difference between the injection synchronization light and the resonant frequency is fed back to the actuator 18 of the resonator 13B, but the information on the difference may be fed back to the seed light source 31.

Operational characteristics of the vertical external-cavity surface-emitting laser 10C are similar to those of the first embodiment described above with reference to FIGS. 5A to 5C and FIGS. 6A to 6C. In addition, in the second embodiment, the center wavelength of the light pulse that is output by switching to the low Q factor is controlled to take the desired wavelength.

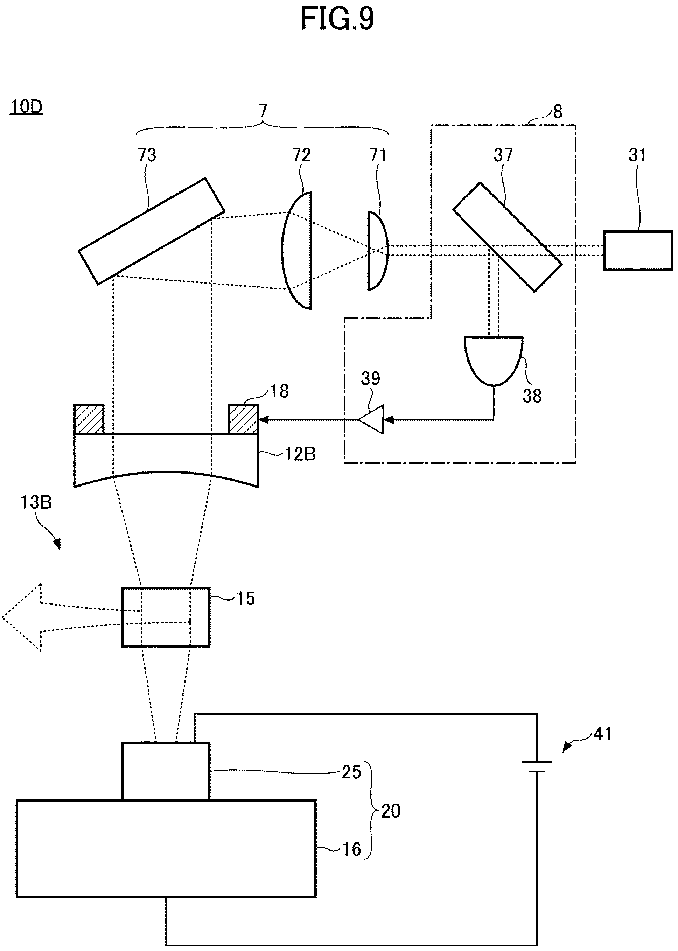

FIG. 9 is a schematic diagram of a vertical external-cavity surface-emitting laser 10D, which is a modification example of FIG. 8. Basic operations of the vertical external-cavity surface-emitting laser 10D are the same as those of the vertical external-cavity surface-emitting laser 10C of FIG. 8, except that the vertical external-cavity surface-emitting laser 10D is excited by a current.

A current source 41 is connected to the VECSEL chip 20. At least part of the heat sink 16 may be formed with a conductive material and used as an electrode for current injection. Another electrode may be provided on a surface of the laminated body 25, for example, at a position that does not obstruct the reciprocation of the light. Light generated by recombination of the carrier excited by the current injection is emitted from the VECSEL active layer 14A, reciprocates inside the resonator 13B to be amplified, and light energy is accumulated in the resonator 13B. When the light power accumulated in the resonator 13B has reached a sufficient level, the Q switch 15 is switched to the low Q side and a light pulse is output.

The present invention is described above based on specific examples, but the present invention is not limited to the configuration examples described above. For example, the resonator 13B provided with the Q switch 15 is not limited to a resonator using two mirrors, and may be a triangle ring-type resonator using three mirrors or a bow tie-type resonator using four mirrors. An optical fiber may be applied to at least part of the resonator. The vertical external-cavity surface-emitting laser 10A in FIG. 4 may be made to be a current excitation type.

The transverse mode adjustment and/or the longitudinal mode adjustment between the seed light source and the resonator is not limited to the examples illustrated in the drawings, and an appropriate control mechanism may be employed in accordance with the arrangement configuration of the resonator. The operations of the Q switch 15 may be such that a period of time until the power in the resonator reaches a steady-state value is observed in advance, and a drive pulse is applied to the Q switch 15 at that time interval. Alternatively, a photodetector for monitoring may be provided on part of the mirror constituting the resonator to monitor the light power in the resonator.

In both of the first and second embodiments, high-power pulses may be efficiently output by using a surface-emitting laser medium with favorable characteristics such as low cost, high reliability, low noise, good mode quality and the like. The vertical external-cavity surface-emitting lasers according to the embodiments may be applied in a variety of fields including cutting, processing, optical measurement, and photoexcitation of a special material.

This application claims priority based on Japanese Patent Application No. 2019-207122, filed on November 15, 2019, the entire contents of which are included herein by reference.

Reference Signs List

2 Condensing lens
3 Excitation light source
7 Optical system for transverse mode adjustment
8 Feedback system
10, 10A, 10B, 10C, 10D Vertical external-cavity surface-emitting laser
11, 12, 12B Mirror
11A DBR mirror
13, 13A, 13B Resonator
14 Semiconductor laser medium
14A VECSEL active layer
15 Q switch
16 Heat sink
18 Actuator
20 VECSEL chip
31 Seed light source
32 Isolator
41 Current source

**Claims**

1. A vertical external-cavity surface-emitting laser, comprising:

   a resonator comprising at least two mirrors;
   a semiconductor laser medium disposed in the resonator; and

a Q switch provided in the resonator.

2. The vertical external-cavity surface-emitting laser according to claim 1, wherein:
the Q switch is configured such that, when power of light amplified by the semiconductor laser medium has reached a predetermined level, the Q switch lowers a Q factor of the resonator from a first level to a second level that is lower than the first level to output a light pulse.

3. The vertical external-cavity surface-emitting laser according to claim 2, wherein:
the Q switch is configured such that, when the power approaches or reaches a steady-state value, the Q switch switches the Q factor to the second level.

4. The vertical external-cavity surface-emitting laser according to claim 2 or 3, wherein
the Q switch is configured to switch the Q factor mechanically, acoustically, or electro-optically.

5. The vertical external-cavity surface-emitting laser according to any one of claims 1 to 4, wherein
one of the mirrors constituting the resonator and the semiconductor laser medium are formed on an identical chip.

6. The vertical external-cavity surface-emitting laser according to claim 5, wherein
the semiconductor laser medium is an active layer joined to the one of the mirrors constituting the resonator.

7. The vertical external-cavity surface-emitting laser according to claim 2, wherein
before the Q factor being switched from the first level to the second level, one of the mirrors constituting the resonator causes injection synchronization light to enter from a surface on an opposite side to a surface facing the semiconductor laser medium.

8. The vertical external-cavity surface-emitting laser according to claim 7, wherein
a resonator length of the resonator is an integral multiple of a wavelength of the injection synchronization light.

9. The vertical external-cavity surface-emitting laser according to any one of claims 1 to 8, further comprising:
an excitation light source configured to excite the semiconductor laser medium.

10. The vertical external-cavity surface-emitting laser according to any one of claims 1 to 8, further comprising:
a current source configured to excite the semicon-

ductor laser medium.

# FIG.1A

<HIGH Q>

10

12

13

11

15

Q SWITCH

14

SEMICONDUCTOR
LASER MEDIUM

# FIG.1B

<LOW Q>

10

12

13

11

15

Q SWITCH

14

SEMICONDUCTOR
LASER MEDIUM

# FIG.2

10A

12

13A

11A

15

Q SWITCH

| VECSEL ACTIVE LAYER | ~14A |
|---|---|
| DBR MIRROR | ~11A |
| HEAT SINK | ~16 |

20

# FIG.3

~12

20

~17

~14A

25

~11A

~16

# FIG.4

# FIG.5A

LIGHT POWER TRANSMITTANCE $(A_Q)$

# FIG.5B

POWER INSIDE RESONATOR

# FIG.5C

RESONATOR OUTPUT

# FIG.6A

LIGHT POWER TRANSMITTANCE ($A_Q$)

# FIG.6B

POWER INSIDE RESONATOR

# FIG.6C

RESONATOR OUTPUT

# FIG.7A

<HIGH Q>

10B

SEED LIGHT SOURCE ~31

ISOLATOR ~32

Q SWITCH ~15

VECSEL ACTIVE LAYER ~14A

DBR MIRROR ~11A

HEAT SINK ~16

12B
13B
11A
20

# FIG.7B

<LOW Q>

<u>10B</u>

| SEED LIGHT SOURCE | ~31 |

| ISOLATOR | ~32 |

15

| Q SWITCH |

12B

13B

11A

| VECSEL ACTIVE LAYER | ~14A |
| DBR MIRROR | ~11A | 20 |
| HEAT SINK | ~16 |

# FIG.8

# FIG.9

**EP 4 060 834 A1**

<div style="text-align:center">**INTERNATIONAL SEARCH REPORT**</div>

| International application No. |
| --- |
| PCT/JP2020/040375 |

**A. CLASSIFICATION OF SUBJECT MATTER**
H01S 5/183(2006.01)i; H01S 3/11(2006.01)i; H01S 5/14(2006.01)i
FI: H01S5/183; H01S5/14; H01S3/11

According to International Patent Classification (IPC) or to both national classification and IPC

**B. FIELDS SEARCHED**

Minimum documentation searched (classification system followed by classification symbols)
H01S5/183; H01S3/11; H01S5/14

Documentation searched other than minimum documentation to the extent that such documents are included in the fields searched
|  |  |
| --- | --- |
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | US 2005/0281309 A1 (SAMSUNG ELECTRONICS CO., LTD.) 22 December 2005 (2005-12-22) paragraphs [0028]-[0038], fig. 3 | 1-6, 9-10<br>7-8 |
| Y<br>A | JP 2005-039093 A (NATIONAL INSTITUTES OF NATURAL SCIENCES OKAZAKI ADMINISTRATION OFFICE) 10 February 2005 (2005-02-10) paragraphs [0020]-[0034], [0042]-[0043], fig. 5A | 1-6, 9-10<br>7-8 |
| Y | JP 2015-126040 A (RICOH CO., LTD.) 06 July 2015 (2015-07-06) paragraph [0032], fig. 4-5, 8 | 10 |
| A | JP 2008-141175 A (CANON INC.) 19 June 2008 (2008-06-19) paragraph [0036], fig. 1 | 7-8 |

☐ Further documents are listed in the continuation of Box C. ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 14 December 2020 (14.12.2020) | 22 December 2020 (22.12.2020) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
| --- | --- |

Form PCT/ISA/210 (second sheet) (January 2015)

**INTERNATIONAL SEARCH REPORT**
Information on patent family members

International application No.

PCT/JP2020/040375

| Patent Documents referred in the Report | Publication Date | Patent Family | Publication Date |
|---|---|---|---|
| US 2005/0281309 A1 | 22 Dec. 2005 | KR 10-2005-0120483 A | |
| JP 2005-039093 A | 10 Feb. 2005 | US 2005/0036531 A1 paragraphs [0031]-[0050], [0058]-[0062], fig. 5 | |
| JP 2015-126040 A | 06 Jul. 2015 | (Family: none) | |
| JP 2008-141175 A | 19 Jun. 2008 | US 2008/0106720 A1 paragraph [0043], fig. 1 EP 1921721 A1 KR 10-2008-0041578 A TW 200840166 A | |

Form PCT/ISA/210 (patent family annex) (January 2015)

**REFERENCES CITED IN THE DESCRIPTION**

**Patent documents cited in the description**

- JP 2008177226 A
- JP 4042979 A
- JP 2019207122 A